(19) Europäisches Patentamt
European Patent Office
Office européen des brevets

(11) EP 0 915 384 A2

(12) EUROPEAN PATENT APPLICATION

(43) Date of publication:
**12.05.1999 Bulletin 1999/19**

(51) Int Cl.[6]: **G03F 7/20**

(21) Application number: **98309014.3**

(22) Date of filing: **04.11.1998**

(84) Designated Contracting States:
**AT BE CH CY DE DK ES FI FR GB GR IE IT LI LU MC NL PT SE**
Designated Extension States:
**AL LT LV MK RO SI**

(30) Priority: **06.11.1997 JP 304232/97**

(71) Applicant: **CANON KABUSHIKI KAISHA**
**Tokyo (JP)**

(72) Inventors:
- **Sugita, Mitsuro**
  **Ohta-ku, Tokyo (JP)**
- **Suzuki, Akiyoshi**
  **Ohta-ku, Tokyo (JP)**

(74) Representative:
**Beresford, Keith Denis Lewis et al**
**BERESFORD & Co.**
**2-5 Warwick Court**
**High Holborn**
**London WC1R 5DJ (GB)**

(54) **Dual exposure method and device manufacturing method using the same**

(57) An exposure method for dual or multiple exposure, wherein a first exposure process is performed by use of interference fringe produced by interference of two light beams, and a second exposure process is performed by use of a light pattern different from the interference fringe, and wherein, in at least one of the first and second exposure processes, a multiplex exposure amount distribution is provided.

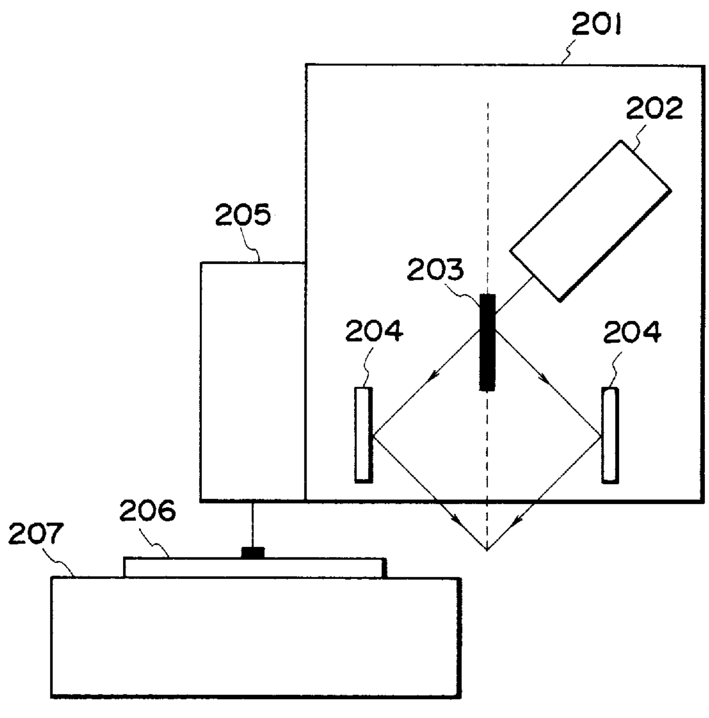


FIG. 20

EP 0 915 384 A2

**Description**

FIELD OF THE INVENTION AND RELATED ART

This invention relates to an exposure method, an exposure apparatus and a device manufacturing method. More particularly, the invention is concerned with a dual or multiple exposure method for printing a fine circuit pattern on a photosensitive substrate, and an exposure apparatus and device manufacturing method based on the dual (multiple) exposure method. The exposure method and apparatus of the present invention is suitably usable, for example, for manufacture of microdevices such as semiconductor chips (e.g., IC or LSI), display devices (e.g., liquid crystal panel), detecting devices (e.g., magnetic head), or image pickup devices (e.g., CCD), for example.

In manufacture of devices such as IC, LSI, or liquid crystal panels, for example, on the basis of photolithography, generally a projection exposure method and a projection exposure apparatus are used, in which a circuit pattern of a photomask or reticle (hereinafter "mask") is projected by a projection optical system onto a photosensitive substrate (hereinafter "wafer") such as a silicone wafer or glass plate having a coating of photoresist, for example, whereby the pattern is transferred (printed) thereto.

In order to meet further increases in density of integration of a device, further miniaturization of a pattern to be transferred to a wafer (that is, further improvement of resolution) as well as further increase of the area of a single chip are required. In projection exposure methods and projection exposure apparatuses which the primary of microfabrication technology, improvements of resolution and exposure area have been attempted to assure that an image of a size (linewidth) of 0.5 micron or less is formed in a wide range.

Figure 19 shows a projection exposure apparatus of known type. Denoted in Figure 19 at 191 is an excimer laser which is a light source for deep ultraviolet light exposure. Denoted at 192 is an illumination optical system, and denoted at 193 is illumination light. Denoted at 194 is a mask, and denoted at 195 is object side exposure light which is emitted from the mask 194 and enters an optical system 196. The optical system 196 comprises a reduction projection optical system. Denoted at 197 is image side exposure light which is emitted from the optical system 196 and impinges on a photosensitive substrate 198. The substrate 198 comprises a wafer. Denoted at 199 is a substrate stage for holding the photosensitive substrate.

Laser light emitted by the excimer laser 191 is directed to a guiding optical system to the illumination optical system 192. By means of the projection optical system 192, the light is adjusted into illumination light 193 having a predetermined light intensity distribution, an orientation distribution, and an opening angle (numerical aperture: NA), for example. The illumination light 193 illuminates the mask 194. The mask 194 has a pattern corresponding to a fine pattern to be formed on the wafer 198 and having a size corresponding to an inverse (e.g., 2x, 4x, or 5x) of the projection magnification of the projection optical system 192, which pattern is formed on a quartz substrate by use of chromium, for example. The illumination light 193 is transmissively diffracted by the fine pattern of the mask 194, whereby object side exposure light 195 is provided. The projection optical system 196 serves to transform the object side exposure light 195 into image side exposure light 197 with which the fine pattern of the mask 194 is imaged upon the wafer 198, at the above-described projection magnification and with sufficiently small aberration. As illustrated in enlarged view at the bottom of Figure 19, the image side exposure light 197 is converged upon the wafer 198 with a predetermined numerical aperture NA (= sinθ), whereby an image of the fine pattern is formed on the wafer 198. For sequentially printing the fine pattern on different regions (shot regions: each being a region for production of one or plural chips), the substrate stage 199 moves stepwise along an image plane of the projection optical system to change the position of the wafer 198 with respect to the projection optical system 196.

However, with current projection exposure apparatuses having an excimer laser as a light source, it is difficult to form a pattern of 0.15 micron or less.

In the projection optical system 196, there is a limitation of resolution in relation to tradeoff between optical resolution and depth of focus, due to the exposure wavelength (wavelength to be used for exposure process). The relation between resolution R and depth of focus DOF of a projection exposure apparatus can be expressed in accordance with Rayleigh equation, as equations (1) and (2) below.

$$R = k_1(\lambda/NA) \quad (1)$$

$$DOF = k_2(\lambda/NA^2) \quad (2)$$

where $\lambda$ is exposure wavelength, NA is numerical aperture at image side that represents brightness of the projection optical system 196, and $k_1$ and $k_2$ are constants which are usually about 0.5 - 0.7. It is seen from equations (1) and (2) that, in order to provide higher resolution with a smaller resolution value R, the numerical aperture NA may be enlarged (enlargement of NA). However, in practical exposure process, the depth of focus DOF of the projection optical system 196 should be not less than a certain value and, therefore, enlargement of numerical aperture NA beyond a certain level is not possible. Thus, for higher resolution, finally it is necessary to make the exposure wavelength $\lambda$ shorter (shortening of wavelength).

However, shorting of wavelength raises a serious problem. That is, there is no glass material available for the projection optical system 196. Almost all glass materials have about zero transmissivity to deep ultraviolet region. While there is a fused silica which can be produced as a glass material in an exposure apparatus with exposure wavelength about 248 nm in accordance with a special manufacturing method, the transmissivity of even such fused silica decreases drastically to exposure wavelength not longer than 193 nm. In the region not longer than 150 nm for a fine pattern of 1.15 micron or less, development of a practical glass material is quite difficult to accomplish. Further, the glass material to be used in deep ultraviolet region must satisfy several conditions such as durability, uniformness of birefringence, optical distortion, and machining characteristic, for example. For these reasons, there is a large problem in the availability of practical glass materials.

In conventional projection exposure methods and projection exposure apparatuses, as described, for formation of a pattern of 0.15 micron or less upon a wafer 198, the exposure wavelength should be shortened to about 150 mn or less. Nevertheless, since there is no practical glass material available for such wavelength region, practically it is very difficult to form a pattern of 0.15 micron or less on the wafer 198.

U.S. Patent No. 5,415,835 shows a process of forming a fine pattern by use of dual-beam interference exposure. With this dual-beam interference exposure process, a pattern of 0.15 micron or less may be formed on a wafer.

Referring to Figure 15, the principle of dual-beam interference exposure will be explained. In accordance with dual-beam interference exposure, laser light from a laser 151 which comprises parallel light having coherency is divided by a half mirror 152 into two light beams. These light beams are then reflected by a flat mirror 153, such that two laser lights (coherent parallel light beams) intersect with each other with an angle not less than zero deg. and not greater than 90 deg., whereby interference fringe is produced at the intersection. A wafer 154 is exposed and sensitized by use of this interference fringe (i.e., the light intensity distribution of it), by which a fine periodic pattern corresponding to the intensity distribution of the interference fringe is formed on the wafer.

When the two light beams intersect at the wafer surface in a state wherein they are inclined with respect to a normal to the wafer surface oppositely by the same angle, the resolution R attainable with this dual-beam interference exposure process can be expressed by equation (3) below.

$$R = \lambda/(4\sin\theta)$$

$$= \lambda/4NA$$

$$= 0.25(\lambda/NA) \qquad (3)$$

where R represents widths of line and space, respectively, that is, widths of bright and dark portions of the interference fringe, respectively, and $\theta$ denotes incidence angle (absolute value) of the two light beams with respect to the image plane, wherein NA = sin$\theta$.

Comparing equation (1) for resolution according to ordinary projection exposure process with equation (3) for resolution according to dual-beam interference exposure process, since resolution R in the dual-beam interference exposure corresponds to that in a case where $k_1 = 0.25$ in equation (1), it is seen that with the dual-beam interference exposure a resolution twice or more higher than that of ordinary projection exposure process ($k_1$ = 0.5 to 0.7) can be provided. Although it is not discussed in the aforementioned U.S. patent, if $\lambda$ = 0.248 nm (KrF excimer laser) and NA = 0.6, a resolution R = 0.10 micron will be attainable.

In accordance with the dual-beam interference exposure process, however, basically, only a simple fringe pattern corresponding to the light intensity distribution of interference fringe (i.e., exposure amount distribution) is attainable. It is not possible to produce a circuit pattern of desired shape upon a wafer.

The aforementioned U.S. Patent No. 5,415,835 proposes a procedure in which, after exposure amount distribution of a simple fringe pattern (i.e., binary exposure amount distribution) is applied to (a resist of) a wafer, an ordinary lithographic process (exposure process) is performed by use of a mask having a certain aperture to apply again a different binary exposure amount distribution to the wafer, to thereby define isolated lines (pattern).

With this exposure method proposed by the aforementioned U.S. Patent No. 5,415,835, however, what can be produced is an ordinary binary exposure amount distribution, through the dual-beam interference exposure process and ordinary exposure process. A more complicated pattern can not be produced.

Further, while the aforementioned U.S. Patent No. 5,415,835 discusses combined use of dual-beam interference exposure process and ordinary exposure process, it does not mention to the structure of exposure apparatus suitable for this combination.

## SUMMARY OF THE INVENTION

It is an object of the present invention to provide a dual or multiple exposure method by which a complicated device pattern can be produced.

It is another object of the present invention to provide a device manufacturing method and/or an exposure apparatus that uses such dual or multiple exposure method.

In accordance with an aspect of the present invention, there is provided an exposure method for dual or multiple exposure, comprising the steps of: performing a first exposure process by use of interference fringe produced by interference of two light beams; and performing a second exposure process by use of a light pattern different from the interference fringe; wherein, in at least one of the first and second exposure processes, a multiplex exposure amount distribution is provided.

In one preferred form of this aspect of the present invention, in the second exposure process a multiplex exposure amount distribution may be applied.

In one preferred form of this aspect of the present invention, the second exposure process may be performed by use of plural masks having different patterns.

In one preferred form of this aspect of the present invention, the second exposure process may be performed by use of a mask with plural transparent regions having different transmissivities.

In one preferred form of this aspect of the present invention, the first exposure process may be performed by use of a pattern of a phase shift mask and a projection exposure apparatus.

In one preferred form of this aspect of the present invention, the first exposure process may be performed by use of an interferometer.

In one preferred form of this aspect of the present invention, the first and second exposure processes may be performed by use of a projection exposure apparatus.

In one preferred form of this aspect of the present invention, the first exposure process may be performed by use of a phase shift mask.

In one preferred form of this aspect of the present invention, in the first exposure process a multiplex exposure amount distribution may be applied.

In accordance with another aspect of the present invention, there is provided a device manufacturing method including a step for transferring a device pattern onto a workpiece by use of an exposure method as recited above.

In accordance with a further aspect of the present invention, there is provided a projection exposure apparatus for performing an exposure method as recited above.

The first and second exposure processes may be performed sequentially or at the same time. When they are performed sequentially, basically either may be performed first.

Here, the word "multiplex" referred to above in relation to the phrase "multiplex exposure amount distribution" means that, unlike binary exposure amount (two levels including zero level exposure amount) to be applied to a photosensitive substrate, more than binary exposure amount (three or more levels including zero level exposure amount) is given. Further, the words "ordinary exposure (process)" are used to refer to an exposure process which is to be done with a resolution lower than that attainable with dual-beam interference exposure and to be done with a pattern different from that used in the dual-beam interference exposure. A typical example of such ordinary exposure process is projection exposure for projecting a mask pattern through a projection exposure apparatus such as shown in Figure 19.

Each of dual-beam interference exposure process and ordinary exposure process to be performed in the present invention, may comprises a single exposure step or plural exposure steps. In the latter case, in each step a different exposure amount may be applied to a photosensitive substrate.

In an exposure method and exposure apparatus according to the present invention, if the second exposure process is to be performed through projection exposure, the first and second exposure process may use exposure wavelengths not greater than 400 nm, preferably no greater than 250 nm. Exposure light of a wavelength not greater than 250 mm may be available from KrF excimer laser (about 248 nm) or ArF excimer laser (about 193 nm).

An exposure apparatus according to the present invention may comprise a projection optical system for projecting a pattern of a mask onto a wafer, and a mask illumination system for selectively providing partially coherent illumination and coherent illumination. Ordinary exposure process may be performed with partially coherent illumination, while dual-beam interference illumination may be performed with coherent illumination. Here, the words "partially coherent illumination" are used to refer an illumination mode with σ (= "numerical aperture of illumination optical system" divided by "numerical aperture of projection optical system") which is larger than zero and smaller than 1. The words "coherent illumination" are used to refer to an illumination mode with σ which is equal to or close to zero, it being very small as compared with σ of partially coherent illumination.

The exposure apparatus described just above, may use an exposure wavelength not greater than 400 nm, preferably not greater than 250 nm. Exposure light of a wavelength not greater than 250 mm may be available from KrF excimer laser (about 248 nm) or ArF excimer laser (about 193 nm).

One preferred embodiment of the present invention to be described later, includes an optical system for a mask illumination optical system that enables interchanging between partially coherent illumination and coherent illumination.

An exposure system according to another preferred embodiment of the present invention may comprise a combination of dual-beam interference exposure apparatus and ordinary (projection) exposure apparatus, and a movement stage for holding a workpiece (photosensitive substrate) and being used in both of these apparatuses. This exposure system may use an exposure wavelength not greater than 400 nm, preferably not greater than 250 nm. Exposure light of a wavelength not greater than 250 mm may be available from KrF excimer laser (about 248 nm) or ArF excimer laser (about 193 nm).

These and other objects, features and advantages of the present invention will become more apparent upon a consideration of the following description of the preferred embodiments of the present invention taken in conjunction with the accompanying drawings.

## BRIEF DESCRIPTION OF THE DRAWINGS

Figure 1 is a flow chart of an exposure method according to an embodiment of the present invention.

Figures 2A and 2B are schematic views, respectively, for explaining an exposure pattern through a dual-beam interference exposure process.

Figures 3A and 3B are graphs, respectively, for explaining exposure sensitivity characteristic of resist materials.

Figure 4 is a schematic view for explaining a pattern formation with a development process.

Figure 5 is a schematic view for explaining an exposure pattern through an ordinary dual-beam interference exposure process.

Figure 6 is a schematic view for explaining an exposure pattern through a dual-beam interference exposure according to the present invention.

Figures 7A and 7B are schematic views, respectively, for explaining an example of exposure pattern (lithographic pattern) to be produced in a first embodiment of the present invention.

Figures 8A and 8B are schematic views, respectively, for explaining another example of exposure pattern (lithographic pattern) to be produced in the first embodiment of the present invention.

Figures 9A and 9B are schematic views, respectively, for explaining another example of exposure pattern (lithographic pattern) to be produced in the first embodiment of the present invention.

Figure 10 is a schematic view for explaining a gate pattern.

Figures 11A, 11B, 11C and 11D are schematic views, respectively, for explaining a second embodiment of the present invention.

Figure 12 is a schematic view for explaining a dual-beam interference exposure pattern in a third embodiment of the present invention.

Figure 13 is a schematic view for explaining a pattern formed with two-dimensional blocks, in the third embodiment of the present invention.

Figure 14 is a schematic view for explaining an example of exposure pattern to be formed in accordance with the third embodiment of the present invention.

Figure 15 is a schematic view of a main portion of an example of dual-beam interference exposure apparatus.

Figure 16 is a schematic view of a main portion of an example of projection exposure apparatus for performing dual-beam interference exposure.

Figure 17 is a schematic view for explaining an example of mask and illumination method which can be used in the apparatus of Figure 16.

Figure 18 is a schematic view for explaining another example of mask and illumination method which can be used in the apparatus of Figure 16.

Figure 19 is a schematic view of a projection exposure apparatus of known type.

Figure 20 is a schematic view of an example of dual-beam interference exposure apparatus according to the present invention.

Figure 21 is a schematic view of an example of high-resolution exposure apparatus according to the present invention.

Figure 22 is a schematic view of another example of high-resolution exposure apparatus according to the present invention.

## DESCRIPTION OF THE PREFERRED EMBODIMENTS

Referring to Figures 1 - 9, an exposure method according to an embodiment of the present invention will be described.

Figure 1 is a flow chart showing the exposure method in this embodiment of the present invention. Figure 1 illustrates a dual-beam interference exposure step, a projection exposure step (ordinary exposure step), and a developing step, in respective blocks with flow. The order of the dual-beam interference exposure step and the projection exposure step may be reversed to that shown in Figure 1. If any one of these steps comprises plural exposures, these steps may be made alternately. Between these exposure steps, a step for fine alignment operation may be included, while not shown in the drawings.

In exposure operation according to the flow chart of Figure 1, first a wafer (photosensitive substrate) is exposed with a periodic pattern (interference fringe) such as shown in Figure 2A through the dual-beam interference exposure. Numerals in Figure 2A denote the amount of exposure. Those regions with hatching in Figure 2A correspond to portions with exposure amount 1 (actually, arbitrary), while the blank regions correspond to portions with zero exposure amount.

For development of such periodic pattern after exposure, usually the exposure threshold $E_{th}$ for the resist of the photosensitive substrate is set between exposure amounts 0 and 1, as illustrated at the bottom of Figure 2B. The upper portion of Figure 2B illustrates a lithographic pattern (pattern with concaved and protruded portions) to be produced finally.

Figures 3A and 3B illustrate exposure amount dependency of film thickness after development and exposure threshold, with regard to the resist of the photosensitive substrate, in this case, the graphs being plotted in relation to a positive type resist and negative type resist. The film thickness after development becomes zero, with a level higher than the exposure threshold in the case of positive type resist, and with a level lower than the exposure threshold in the case of negative type resist.

Figure 4 is a schematic view for explaining, in relation to the positive and negative type resists, formation of a lithographic pattern after a development process and an etching process after the exposure process is performed as described above.

In this embodiment, as compared with usual exposure sensitivity setting described above, as shown in Figure 5 (the same as Figure 2A) and Figure 6 the exposure threshold $E_{th}$ for the resist of the photosensitive substrate is set to be larger than 1 where the largest exposure amount with the dual-beam interference exposure is taken as 1. In this photosensitive substrate, if the exposure pattern (exposure amount distribution) provided only by the dual-beam interference exposure (Figure 2) is developed, because of insufficient exposure amount there is no portion produced wherein the film thickness becomes zero with the development, although there is small thickness variation. Thus, no lithographic pattern is formed through the etching. This can be regarded as disappearance of dual-light interference exposure pattern. Here, while the invention is described with reference to a case where negative type resist is used, the invention is applicable also to a case where positive type resist is used.) In Figure 6, the upper portion illustrate a lithographic pattern (no pattern is formed). The graph at the bottom of the drawing illustrates the relation between the exposure amount distribution and the exposure threshold value. Reference character $E_1$ at the bottom denotes the exposure amount in the dual-beam interference exposure, and reference character $E_2$ denotes the exposure amount in the ordinary projection exposure.

In this embodiment, an exposure pattern of high resolution which may otherwise disappear only through dual-beam interference exposure is mixed with an exposure pattern through ordinary projection exposure, to assure that only a desired region is selectively exposed by an amount greater than the exposure threshold for a resist, such that a desired lithographic pattern is finally produced.

Figure 7A illustrates an exposure pattern through ordinary projection exposure. In this embodiment, the resolution of this ordinary projection exposure is about a half of that of the dual-beam interference exposure. Thus, the linewidth of exposure pattern with the projection exposure is illustrated as about twice of the linewidth of exposure pattern through the dual-beam interference exposure.

When the projection exposure process for defining the exposure pattern of Figure 7A is performed, after dual-beam interference exposure process of Figure 5 without development process, superposedly to the same region of the same resist, the total exposure amount distribution of this resist is such as shown in the graph at the bottom of Figure 7B. Here, since the ratio between the exposure amount $E_1$ of dual-beam interference exposure and the exposure amount $E_2$ of projection exposure is 1:1 and the exposure threshold $E_{th}$ for the resist is set to be between exposure amount $E_1$ (= 1) and the sum (= 2) of the exposure amount $E_1$ and exposure amount $E_2$, a lithographic pattern such as shown in the upper portion of Figure 7B can be produced. The isolated line pattern shown in the upper portion of Figure 7B has a resolution determined by the dual-beam interference exposure and, additionally, it is not a simple periodic pattern. Thus, it is seen that a pattern of high resolution, greater than the resolution attainable with ordinary projection exposure, is produced.

If it is assumed that a projection exposure process that can produce an exposure pattern of Figure 8 (i.e., projection exposure of a linewidth twice the exposure pattern of Figure 5 and with an exposure amount higher than the exposure threshold (here, exposure amount twice higher than the threshold)) is performed, after the dual-beam interference exposure process of Figure 5 and without development process, superposedly to the same region of the same resist, then the total exposure amount distribution on the resist will be such as illustrated in Figure 8B. Thus, the exposure pattern through the dual-beam interference exposure disappears, and finally only a lithographic pattern through projection exposure is produced.

The same concept applies also to a case where a linewidth three times larger than the exposure pattern of Figure 5 is to be produced, as illustrated in Figures 9A and 9B. For an exposure pattern of a linewidth four times larger or more, basically from the combination of exposure pattern with double linewidth and exposure pattern with triple linewidth, the linewidth of finally produced lithographic pattern is apparent. Any lithographic pattern that can be accomplished through projection exposure can be produced in this embodiment.

By adjusting the exposure amount distribution (absolute value and distribution) through the dual-beam interference exposure and projection exposure described above as well as by adjusting threshold level for a resist of a photosensitive substrate, a circuit pattern which comprises one of various combinations of patterns such as illustrated in Figures 6, 7B, 8B and 9B and which has a minimum linewidth corresponding to the resolution of dual-beam interference exposure (i.e., pattern of Figure 7B), can be produced.

The principle of exposure method in this embodiment of the present invention may be summarized as follows:

(1) A pattern region not exposed by projection exposure, that is, a dual-beam interference exposure pattern less than an exposure threshold of a resist, disappears with developing process.

(2) As regards a pattern region of projection exposure made with an exposure amount not larger than the exposure threshold of the resist, an exposure pattern having a resolution of dual-beam interference exposure as determined by the combination of the projection exposure and dual-beam interference exposure, is produced.

(3) As regards a pattern region of projection exposure made with an exposure amount not less than the exposure threshold, a desired pattern (corresponding to a mask) is produced, like the projection exposure.

It is an additional advantage of exposure method that, in the portion of highest resolution dual-beam interference exposure, a depth of focus which is remarkably larger than that with ordinary exposure is attainable.

In the foregoing description, as regards the order of dual-beam interference exposure and projection exposure, the dual-beam interference exposure is made first. However, the order is not limited to this.

Next, another embodiment will be described.

This embodiment concerns a circuit pattern (lithography pattern) comprising what can be called a gate-like pattern, such as shown in Figure 10, to be produced through exposure process.

The gate pattern shown in Figure 10 has a minimum linewidth 0.1 micron in a lateral direction, i.e., along a line A-A in the drawing, while it is 0.2 micron or more in a longitudinal direction. In accordance with this embodiment of the present invention, for a two-dimensional pattern in which high resolution is required only with respect to a one-dimensional direction, dual-beam interference exposure may be performed only with respect to the one-dimensional direction for which high resolution is required.

Referring to Figures 11A - 11D, examples of combination of dual-beam interference exposure only in one-dimensional direction with ordinary projection exposure according to this embodiment, will be described.

Figure 11A shows a periodic exposure pattern made through dual-beam interference exposure only with respect to one-dimensional direction. This exposure pattern has a period of 0.2 micron, and this exposure pattern corresponds to a line-and-space pattern of a linewidth 0.1 micron. Numerals in the lower portion of Figure 11A denote exposure amount.

An exposure apparatus that accomplish such dual-beam interference exposure described above, may be one as shown in Figure 15 that includes a wave dividing and combining optical system having a laser 151, a half mirror 152 and a flat mirror 1534.

Alternatively, it may be a projection exposure apparatus such as shown in Figure 16 with its mask and illumination method being arranged such as shown in Figure 17 or 18.

The exposure apparatus of Figure 15 will be described in detail.

In the exposure apparatus of Figure 15, two light beams to be combined with each other as described are obliquely incident on a wafer 154 at an angle θ. The linewidth of interference fringe pattern (exposure pattern) formed on the wafer 154 can be expressed by equation (3) set forth above. The relation between the angle θ and the numerical aperture NA at the image plane side of the wave dividing and combining optical system is NA = sinθ. The angle θ can be adjusted and set as desired by changing the angles of a pair of flat mirrors 153, respectively. If the angle θ of the paired flat mirrors is set large, the linewidth of fringes of the interference fringe pattern becomes smaller. For example, if the two light beams have a wavelength 248 nm (KrF excimer laser), even with θ = 38 deg., an interference fringe pattern of a fringe linewidth of about 0.1 micron can be produced. Here, in this case, NA = sinθ = 0.62. As a matter of course, if the angle θ is made larger than 38 deg., a higher resolution is attainable.

Next, an exposure apparatus shown in Figures 16 - 18 will be described.

The exposure apparatus of Figure 16 is a projection exposure apparatus having an ordinary reduction projection optical system which comprises a number of lenses. Currently, an apparatus of NA 0.6 or more with respect to an exposure wavelength 248 nm is available.

Denoted in Figure 16 at 161 is a mask, and denoted at 162 is exposure light on the object side which is emitted from the mask 161 and enters an optical system 163. The optical system 163 comprises a projection optical system. Denoted at 164 is an aperture stop, and denoted at 165 is exposure light on the image side which is emitted from the projection optical system 163 and impinges on a wafer 166. The wafer 166 comprises a photosensitive substrate. Reference numeral 167 denotes the position of light, in a pair of dots, upon a pupil plane corresponding to the circular opening of the stop 164. Figure 16 is a schematic view which shows the state in which dual-beam interference exposure is being performed. Each of exposure light 162 on the object side and exposure light 165 on the image side comprises two parallel light beams, as compared with ordinary projection exposure shown in Figure 19.

In order to perform dual-beam interference exposure with use of an ordinary projection exposure apparatus such as shown in Figure 16, its mask and its illumination method may be set as shown in Figure 17 or 18. Three examples will be described below.

Figure 17 at (A) shows a Levensen type phase shift mask which comprises a mask having light blocking portions 171 of chromium, with a pitch $P_0$ which is 0 as can be expressed by equation (4) below, as well as phase shifters 172 of pitch $P_{0S}$ as can be expressed by equation (5) below.

$$P_0 = P/M = 2R/M = \lambda/M\cdot(2NA) \quad (4)$$

$$P_{0S} = 2P_0 = \lambda/M\cdot(NA) \quad (5)$$

where M is projection magnification of the projection optical system 163, λ is exposure wavelength, and NA is numerical aperture of the projection optical system 163 on the image side.

On the other hand, a mask shown in Figure 17 at (B) is a shifter edge type phase shift mask, and it is arranged like Levensen type to provide phase shifters 181 of pitch $P_{0S}$ that satisfy equation (5) above.

In order to use the phase shift mask of Figure 17, at (A) or (B), to perform dual-beam interference exposure, the mask may be illuminated with coherent illumination wherein $\sigma = 0$ or a value close to 0. More specifically, parallel light is projected to the mask in a direction perpendicular to the mask surface (in a direction parallel to the optical axis).

With this illumination, as regards zero-th order transmissively diffractive light from the mask in the aforementioned perpendicular direction, since phase differences of adjacent transmissive light rays provided by phase shifters are π and canceled with each other, there is no such light produced. As regards positive and negative first order diffractive light, two parallel light beams are produced from the mask symmetrically with respect to the optical axis of the projection optical system 163, and they provide two exposure lights on the object side, shown in Figure 16. As regards diffractive light rays of second order or higher, they do not enter the aperture of the aperture stop 164 of the projection optical system 163. Thus, they do not contribute to imaging.

A mask shown in Figure 18 comprises a mask having light blocking portions 171 of chromium, with a pitch $P_0$ which can be expressed by equation (6) similar to equation (4).

$$P_0 = P/M = 2R/M = \lambda/M\cdot(2NA) \quad (6)$$

where M is projection magnification of the projection optical system 163, λ is exposure wavelength, and NA is numerical aperture of the projection optical system 163.

For the mask of Figure 18 having no phase shifter, oblique illumination with one or two parallel light beams is performed. The incidence angle $\theta_0$ of the parallel light upon the mask is set to satisfy equation (7) below. When two parallel light beams are used, the mask is illuminated with parallel lights oppositely inclined with each other by an angle $\theta_0$ with reference to the optical axis.

$$\sin\theta_0 = M \times NA \quad (7)$$

where M is projection magnification of the projection optical system 163, and NA is numerical aperture of the projection optical system 163.

When the mask of Figure 18 without phase shifter is illuminated by oblique illumination with use of parallel light satisfying equation (7), there are produced two light beams from the mask to provide two object side exposure lights 162 (Figure 16): that is, zero-th order transmissively diffractive light which advances at an angle $\theta_0$ with respect to the optical axis, and negative first order transmissively diffractive light which advances along a light path symmetrical with the path of zero-th order transmissively diffractive light with respect to the optical axis of the projection optical system. These two light beams enter the aperture of the aperture stop 164 of the projection optical system 163, by which imaging is performed.

In the present invention, oblique illumination with use of one or two parallel light beams as described above, is regarded as one of "coherent illumination".

Dual-beam interference exposure process using an ordinary projection exposure apparatus is such as described above. Since the illumination optical system of the ordinary projection exposure apparatus such as shown in Figure 19 is arranged to perform partially coherent illumination, in this projection exposure apparatus the coherent illumination can be substantially effected, for example, by replacing an aperture stop (not shown) corresponding to $0 < \sigma < 1$ of the illumination optical system of Figure 19 by a peculiar aperture stop corresponding to $\sigma \fallingdotseq 0$.

Referring back to Figures 10 and 11, the embodiment shown in these drawings will be described in greater detail.

In this embodiment, through the ordinary projection exposure (e.g., by partially coherent illumination to a mask with the apparatus of Figure 19) subsequent to the dual-beam interference exposure described hereinbefore, an H-shaped pattern exposure shown in Figure 11B may be performed. Upper half of Figure 11B shows relative positional relationship with the exposure pattern through the dual-beam interference exposure as well as exposure amount at five regions of the exposure pattern defined through the ordinary projection exposure. Lower half of Figure 11B illustrates a map of exposure amount to a resist of the wafer through the ordinary projection exposure, depicted at a resolution of 0.1 micron pitch laterally and longitudinally.

The linewidth of exposure pattern resulting from this projection exposure is 0.2 micron which is twice of that in dual-beam interference exposure. Projection exposure process which produces multiplex exposure amount distribution (different exposure amounts in different regions) such as described above, may use a particular mask having plural stages of transmissivities: that is, for example, a transmissivity T % at apertures of the mask dorresponding to the regions depicted with numeral 1 in the drawing, and a transmissivity 2T % at apertures of the mask corresponding to the regions depicted with numeral 2 in the drawing. According to this method, the projection exposure can be accomplished through a single exposure. As regards the exposure amount ratio upon the wafer (photosensitive substrate) in these exposure processes when the above-described particular mask is used, there is a relation "dual-beam interference exposure" : "projection exposure at apertures with transmissivity T" : "projection exposure with transmissivity 2T" = 1:1:2.

Another method for accomplishing projection exposure with different exposure amounts at different regions, may be a method wherein two types of masks effective to produce exposure patterns such as shown in upper half and lower half of Figure 11D are used to perform exposures sequentially. In that occasion, since the exposure amount with each mask may be single stage (level), the transmissivity of apertures of the mask may also be single stage. As regards the exposure amount ratio upon the wafer (photosensitive substrate) in this case, there is a relation "dual-beam interference exposure" : "first projection exposure" : "second projection exposure" = 1:1:1.

Next, the manner of formation of a fine circuit pattern (Figure 10) through a combination of dual-beam interference exposure and ordinary projection exposure as described above, will be explained. In this embodiment, there is no development process between the dual-beam interference exposure and ordinary projection exposure. Thus, within the region wherein exposure patterns through these exposure processes are superposed one upon another, the exposure amounts are accumulated, and the exposure amount (distribution) after accumulation defines a fresh exposure pattern.

Upper half of Figure 11C shows exposure amount distribution (exposure pattern) resulting from accumulation or superposition of exposure pattern of Figure 11A and exposure pattern of Figure 11B, in this embodiment. Lower half of Figure 11C shows a pattern which can be defined as a result of development process made to this exposure pattern. This embodiment uses a wafer resist having an exposure threshold larger than 1 and smaller than 2. For this reason, only the portion with exposure amount larger than 1 appears as a pattern as a result of development process. The shape and size of the pattern shown in the lower half of Figure 11C correspond to the shape and size of the gate pattern of Figure 10, respectively. It is seen therefore that, in accordance with the exposure method of this embodiment of the present invention, a circuit pattern with fine linewidth such as 0.1 micron, for example, can be produced by a projection exposure apparatus having an illumination optical system with which partially coherent illumination and coherent illumination can be performed selectively.

Referring to Figures 12 - 14, another embodiment of the present invention will be described. In this embodiment, an exposure pattern of multiplex exposure amount distribution (with four exposure amounts of 0, 1, 2 and 3) is produced by superposing an interference fringe pattern of longitudinal fringes and an interference fringe pattern of lateral fringes, by performing dual-beam interference exposure twice.

Figure 12 shows a map of exposure amount distribution of exposure pattern as a longitudinal interference fringe pattern and a lateral interference fringe pattern are superposed one upon another through twice dual-beam interference exposures. Here, in order to expand the variation of exposure pattern (lithography pattern) to be finally obtainable from superposition of dual-beam interference exposure and ordinary exposure, the exposure amount (numeral 2) at bright portions of the longitudinal interference fringe pattern is set to be twice of the exposure amount (numeral 1) at the bright portions of the lateral interference fringe pattern. However, the types of exposure amounts at the bright portions are not limited to two, disclosed.

In the exposure pattern of Figure 12, as a result of twice dual-beam interference exposures, the exposure amount comprises four stages, from 0 to 3. The number of stages of exposure amount through projection exposure which is sufficiently effective in regard to such dual-beam interference exposure, is not less than 5. In this case, the exposure threshold for a resist of a wafer (photosensitive substrate) may be set to be larger than 3 (largest exposure amount in dual-beam interference exposure) and smaller than 4 (largest level of exposure amounts 0, 1, 2, 3 and 4) of projection exposure.

Figure 13 illustrates exposure amounts of exposure patterns which can be provided as a result of projection exposure with five-stage exposure amounts (0, 1, 2, 3, 4). Portions with hatching in Figure 13 correspond to regions above the exposure threshold. These portions finally provide exposure patterns. The illustration in Figure 13 is made in terms of resolution of projection exposure of a half of that in dual-beam interference exposure, and in the unit of a block having a side with a length twice that of Figure 12.

Figure 14 illustrates an example of exposure pattern (lithography pattern) formed in a wider area, by changing the exposure amount of projection exposure in the unit of block. It is seen from Figure 14 that, in accordance with this embodiment, a circuit pattern having a resolution of dual-beam interference exposure and including a wide variety of patterns other than a periodic pattern, can be produced.

In this embodiment, ordinary exposure process is performed in the unit of block which is twice the linewidth of dual-beam interference exposure. However, the invention is not limited to this. Projection exposure may be performed to an arbitrary exposure pattern within the range of resolution of the projection exposure.

Further, in the embodiment described above, the exposure pattern linewidth through dual-beam interference exposure is the same both for longitudinal fringes and lateral fringes. However, they may have different linewidths. Also, desired angles may be chosen for these two types of fringes.

Figure 20 is a schematic view of an example of exposure apparatus for dual-beam interference exposure. Denoted in Figure 20 at 201 is a light interference exposure optical system having a basic structure similar to that of the optical system of Figure 15. Denoted at 202 is a KrF or ArF excimer laser, and denoted at 203 is a half mirror. Denoted at 204 is a flat mirror, and denoted at 205 is an off-axis type alignment optical system with which the positional relation with the optical system 201 is fixed or it can be detected appropriately as a base line (amount). The alignment optical system 205 serves to observe an alignment mark for dual-beam interference, formed on a wafer 206, to detect the position thereof. Denoted at 206 is a wafer (photosensitive substrate). Denoted at 207 is an X-Y-Z stage which is movable along a plane perpendicular to the optical axis of the optical system 201 and along a direction of the optical axis. The position of this stage can be controlled exactly, by means of a laser interferometer, for example. Since the components 205 and 207 have well-known structure and function, detailed description therefor will be omitted.

Figure 21 is a schematic view of a high resolution exposure system which comprises a dual-beam interference exposure apparatus and an ordinary projection exposure apparatus.

Denoted in Figure 21 at 212 is a dual-beam interference exposure apparatus which includes the optical systems 201 and 205 shown in Figure 20. Denoted at 213 is an ordinary projection exposure apparatus which comprises an illumination optical system (not shown), a reticle alignment optical system 214, a wafer alignment optical system (off-axis alignment optical system) 217, and a projection optical system 216 for projecting a circuit pattern of a mask 215 onto a wafer 218 in a reduced scale.

The reticle alignment optical system 214 serves to observe an alignment mark formed on the mask 215 to detect the position thereof. The wafer alignment optical system 217 serves to observe an alignment mark formed on the wafer 206 for projection exposure or to be used also for dual-beam interference, to detect the position thereof. Since the optical systems 214, 216 and 217 have well-known structures and functions, detailed description therefor will be omitted.

Denoted in Figure 21 at 219 is a common X-Y-Z stage to be used in both of the dual-beam interference exposure apparatus 212 and the projection exposure apparatus 213. This X-Y-Z stage 219 is movable along a plane perpendicular to the optical axes of the exposure apparatuses 212 and 213 and along these optical axis directions. The position thereof with respect to X and Y directions can be controlled exactly, by means of a laser interferometer, for example.

The X-Y-Z stage 219 having a wafer 218 held thereon is moved to a station at (1) in Figure 21, and there the position thereof is measured precisely. In accordance with the result of measurement, the X-Y-Z stage is moved to a station at (2) in Figure 21, which corresponds to the exposure station of the exposure apparatus 212. There, dual-beam interference exposure is made to the wafer 218. Subsequently, it is moved to a station at (3) in Figure 21, and the position thereof is measured precisely. Then, it is moved to a station at (4) of Figure 21, corresponding to the exposure station of the exposure apparatus 213, where the projection exposure is made to the wafer 218.

In the exposure apparatus 213, the off-axis alignment optical system 217 may be replaced by a TTL alignment optical system (not shown) for observing an alignment mark of the wafer 218 through the projection optical system 216 to detect the position thereof, or alternatively by a TTR alignment optical system (not shown) for observing an alignment mark of the wafer 218 through the projection optical system 216 and the mask (reticle) 215 to detect the position thereof.

Figure 22 is a schematic view of a high resolution exposure apparatus by which both of dual-beam interference exposure and ordinary projection exposure can be accomplished.

Denoted in Figure 22 at 221 is a KrF or ArF excimer laser, and denoted at 222 is an illumination optical system. Denoted at 223 is a mask (reticle), and denoted at 224 is a mask stage. Denoted at 227 is a projection optical system for projecting a circuit pattern of the mask 223 onto a wafer 228 in a reduced scale. Denoted at 225 is a mask (reticle) changer which is provided to selectively supply, to the mask stage, one of an ordinary reticle, a Levenson type phase shift mask (reticle) as described hereinbefore, an edge shifter type mask (reticle), and a periodic pattern mask (reticle) without phase shifter.

Denoted in Figure 22 at 229 is a common X-Y-Z stage to be used both for dual-beam interference exposure and for projection exposure. This X-Y-Z stage is movable along a plane perpendicular to the optical axis of the optical system 227 and along this optical axis direction. The position thereof can be controlled exactly, by means of a laser interferometer, for example.

The exposure apparatus of Figure 22 includes a reticle alignment optical system (not shown), and a wafer alignment optical system (an off-axis alignment optical system, a TTL alignment optical system or TTR alignment optical system as described with reference to Figure 21).

The illumination optical system 222 of Figure 22 is arranged to alternately provide partially coherent illumination and coherent illumination. In coherent illumination mode, illumination light (1a) or (1b) in the drawing, within block 230, is supplied to one of Levenson type phase shift reticle, edge shifter type reticle, and a periodic pattern reticle without phase shifter. In partially coherent illumination mode, illumination light (2) in block 230 is supplied to a desired reticle. Switching from partially coherent illumination mode to coherent illumination mode may be done by replacing an aperture stop, usually disposed just after a fly's eye lens of the illumination optical system 222, by a coherent illumination stop having an aperture diameter sufficiently smaller than that of the former aperture stop.

By using any one of exposure methods and/or exposure apparatuses described hereinbefore, various microdevices such as semiconductor chips (e.g., IC or LSI), display devices (e.g., liquid crystal panel), detecting devices (e.g., magnetic head), or image pickup devices (e.g., CCD) can be produced.

The present invention is not limited to the forms as described above. Within the scope of the present invention, many modifications are possible. Particularly, the number (times) of exposures in dual-beam interference exposure process and ordinary exposure process as well as the number of stages (levels) of exposure amount, may be chosen appropriately. Further, superposition of exposures may be adjusted, as desired, with a shift, for example. Such adjustment will be effective to expand the variation of circuit patterns to be produced.

In accordance with the embodiments of the present invention as described hereinbefore, it is possible to produce a complicated pattern of a very small linewidth of 0.15 micron or less, by mixture of dual-interference exposure and ordinary exposure.

While the invention has been described with reference to the structures disclosed herein, it is not confined to the details set forth and this application is intended to cover such modifications or changes as may come within the purposes of the improvements or the scope of the following claims.

**Claims**

1. An exposure method for dual or multiple exposure, comprising the steps of:

   performing a first exposure process by use of interference fringe produced by interference of two light beams; and
   performing a second exposure process by use of a light pattern different from the interference fringe;
   wherein, in at least one of the first and second exposure processes, a multiplex exposure amount distribution is provided.

2. A method according to Claim 1, wherein in the second exposure process a multiplex exposure amount distribution is applied.

3. A method according to Claim 2, wherein the second exposure process is performed by use of plural masks having different patterns.

4. A method according to Claim 2, wherein the second exposure process is performed by use of a mask with plural transparent regions having different transmissivities.

5. A method according to Claim 1, wherein the first exposure process is performed by use of a pattern of a phase shift mask and a projection exposure apparatus.

6. A method according to Claim 1, wherein the first exposure process is performed by use of an interferometer.

7. A method according to Claim 1, wherein the first and second exposure processes are performed by use of a projection exposure apparatus.

8. A method according to Claim 7, wherein the first exposure process is performed by use of a phase shift mask.

9. A method according to Claim 1, wherein in the first exposure process a multiplex exposure amount distribution is applied.

10. A device manufacturing method including a step for transferring a device pattern onto a workpiece by use of an exposure method as recited in any one of Claims 1 - 9.

11. A projection exposure apparatus for performing an exposure method as recited in any one of Claims 1 - 9.

12. A semiconductor device manufacturing method comprising the steps of:

    coating a substrate with a resist material having a predetermined exposure threshold;
    performing a first exposure process to expose the resist material to a first exposure pattern;
    performing a second exposure process to expose the substrate to a second exposure pattern different from the first pattern;
    wherein one of the first and second exposure patterns is produced by interference of two light beams, and wherein areas of the resist exposed in the first and second exposure processes receive a cumulative exposure amount greater than said exposure threshold; and
    manufacturing a semiconductor device from the exposed substrate.

**13.** A method according to claim 12, wherein one of the first and second exposure patterns comprises a distribution of a plurality of exposure levels.

**14.** A method according to claim 13, wherein each of said plurality of exposure levels is less than said threshold level.

**15.** A method according to any of claims 12 to 14, wherein the semiconductor device is one of a liquid crystal display device, a detecting device, and an image pick up device.

**16.** An exposure method for transferring a pattern to an object provided with a resist coating having an exposure threshold comprising the steps of:

exposing the resist coating to a first exposure pattern comprising illuminated and non-illuminated areas; and
exposing the resist coating to a second exposure pattern comprising illuminated and non-illuminated areas;
wherein areas of the resist which correspond to illuminated areas in both the first and second exposure patterns receive a cumulative exposure greater than said exposure threshold.

**17.** A method according to claim 16, wherein one of the first and second exposure patterns is produced by interference of two light beams.

**18.** A method according to claim 17 or claim 18 wherein the illuminated areas of the first or second exposure pattern comprise areas of differing exposure levels less than the said threshold level.

**19.** A semiconductor device manufactured by a process including an exposure method according to any of claims 1 to 9 or 16 to 18.

**20.** A liquid crystal display device manufactured by a process including an exposure method according to any of claims 1 to 9 or 16 to 18.

**21.** An exposure apparatus for performing a method according to any of claims 1 to 9 or 15 to 18, comprising:

first optical exposure means for projecting an interference pattern on to an area of a substrate; and
second optical exposure means for projecting a pattern of a first object on to said area of said substrate.

**22.** An exposure apparatus according to claim 21, further comprising alignment means for aligning the projected interference pattern and the projected pattern of the first object.

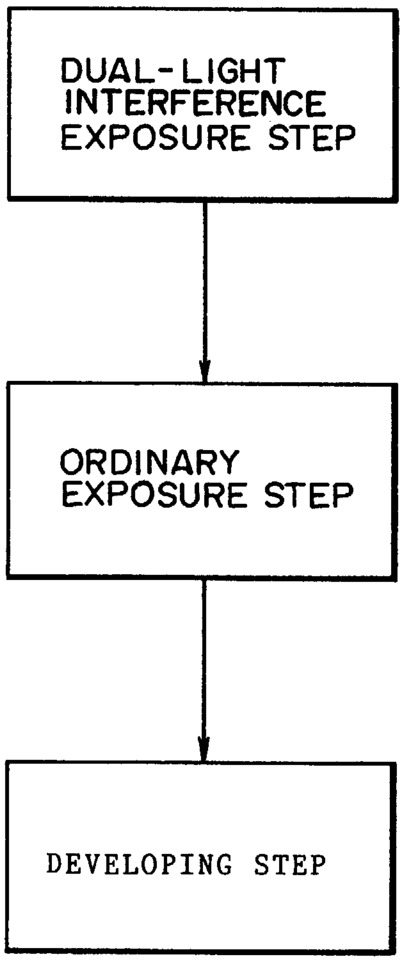
DUAL-LIGHT
INTERFERENCE
EXPOSURE STEP
ORDINARY
EXPOSURE STEP
DEVELOPING STEP

FIG. 1

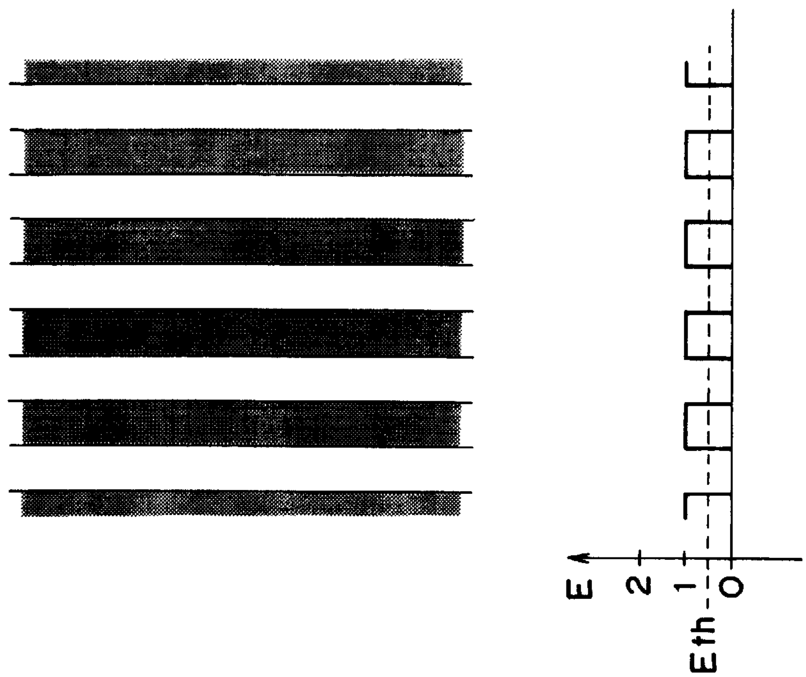


FIG. 2B

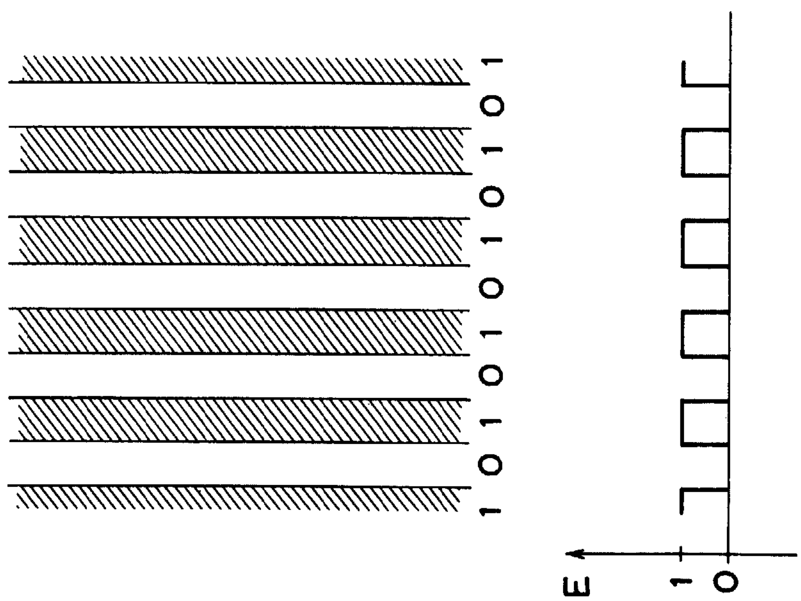


FIG. 2A

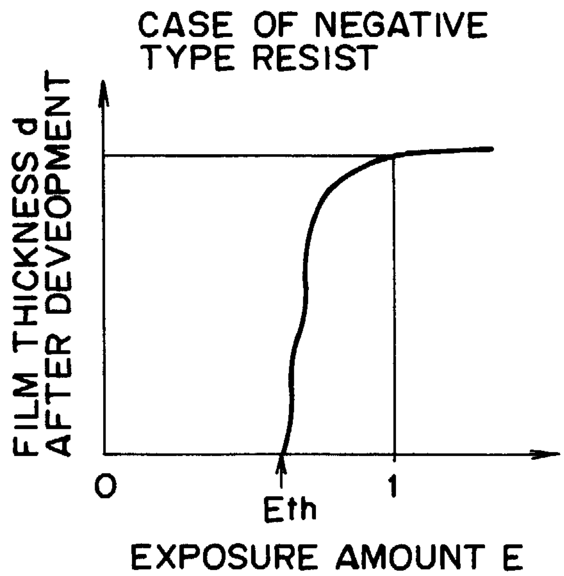
CASE OF NEGATIVE
TYPE RESIST
FILM THICKNESS d
AFTER DEVEOPMENT
0
Eth
1
EXPOSURE AMOUNT E

FIG. 3A

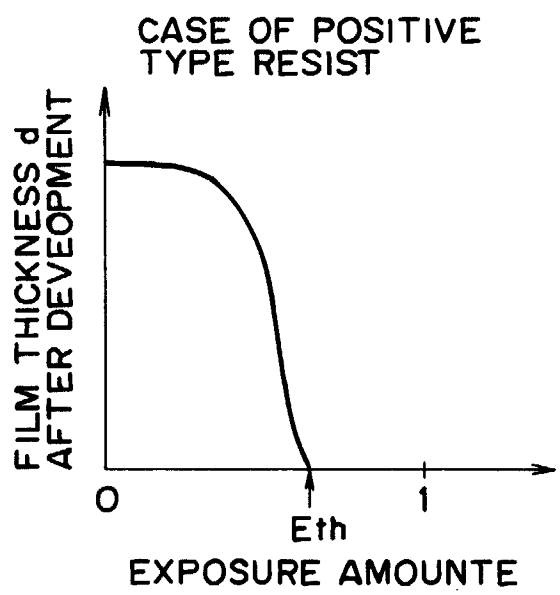
CASE OF POSITIVE
TYPE RESIST
FILM THICKNESS d
AFTER DEVEOPMENT
0
Eth
1
EXPOSURE AMOUNTE

FIG. 3B

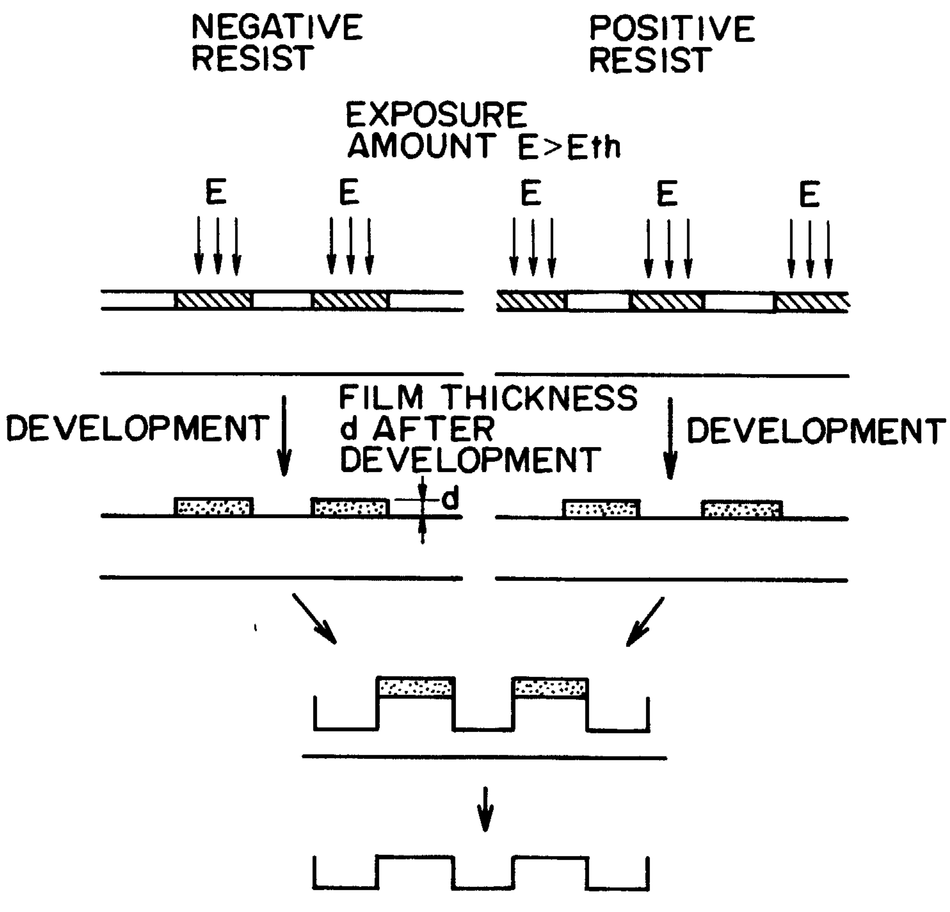
NEGATIVE RESIST
POSITIVE RESIST
EXPOSURE AMOUNT E>Eth
E
E
E
E
E
DEVELOPMENT
FILM THICKNESS d AFTER DEVELOPMENT
DEVELOPMENT
d

FIG. 4

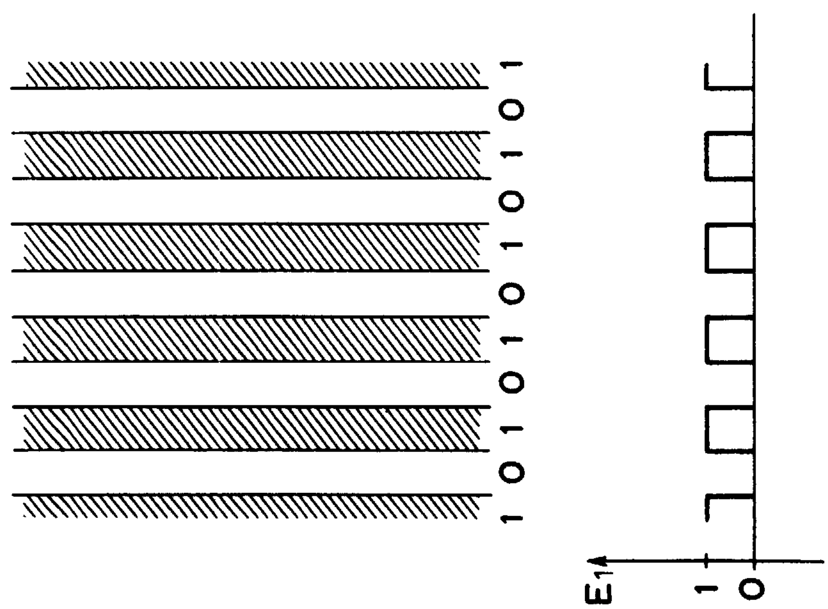


FIG. 5

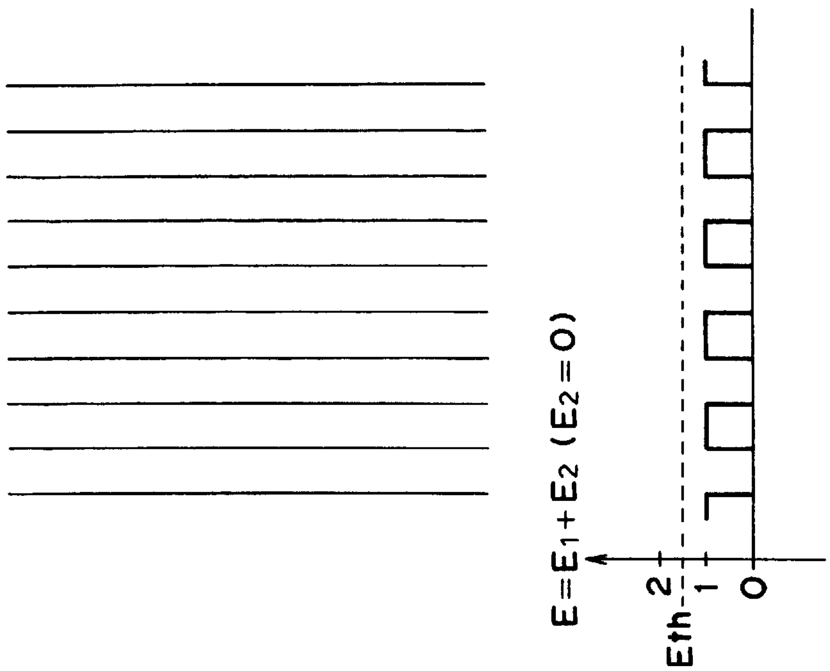


FIG. 6

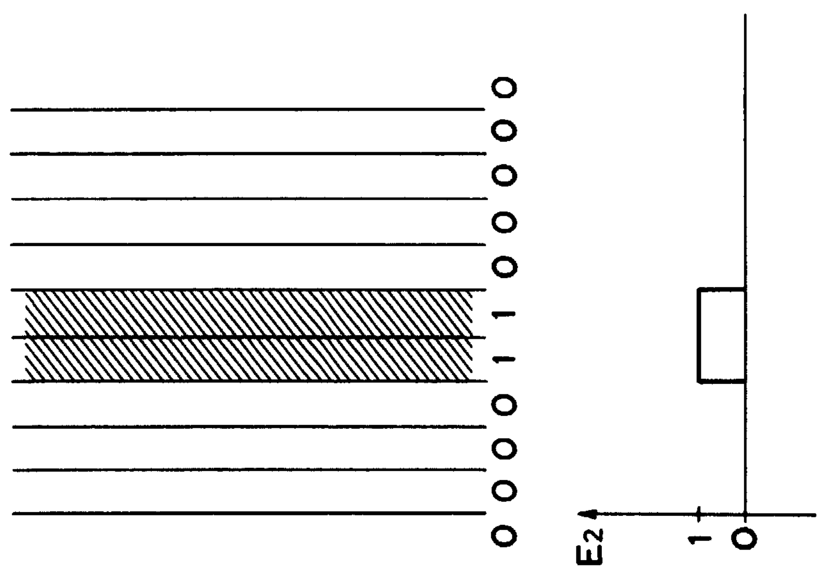


FIG. 7A

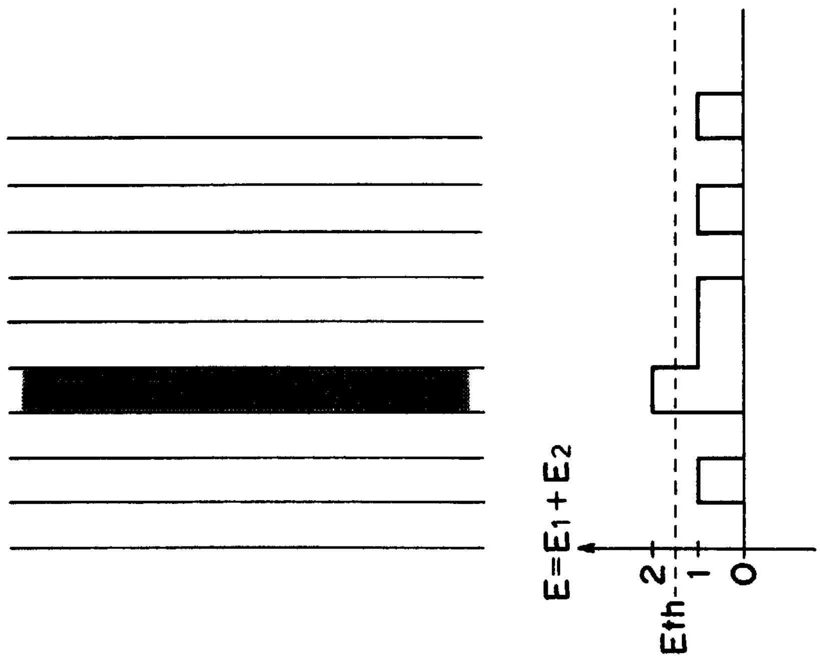


FIG. 7B

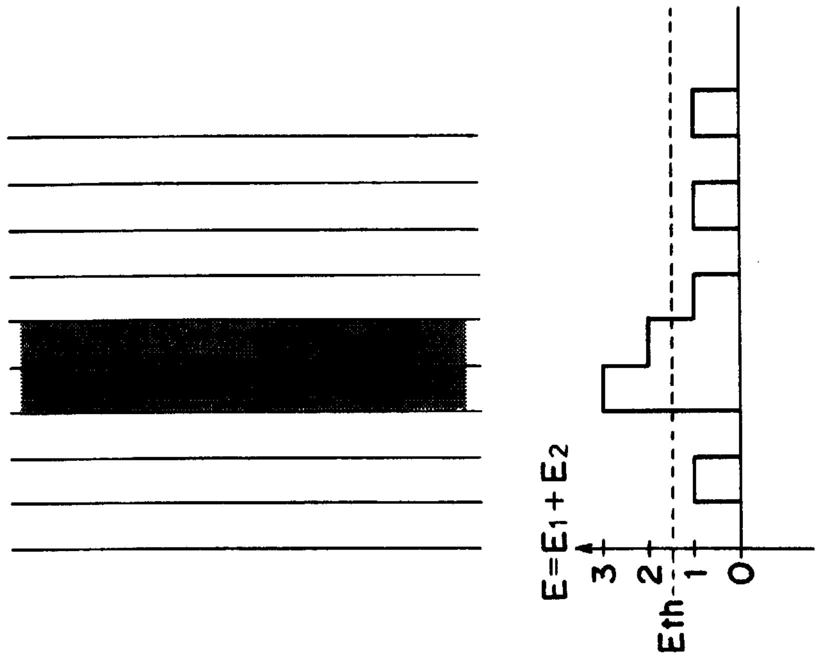


FIG. 8B

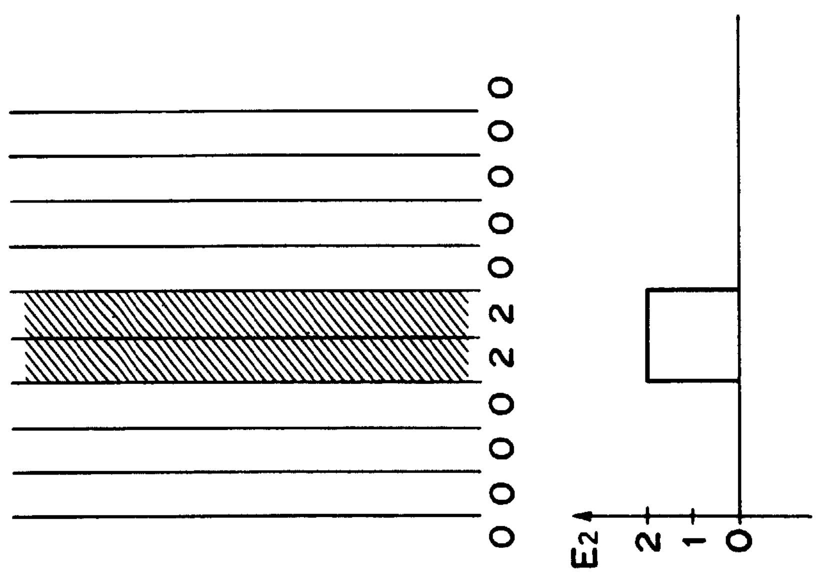


FIG. 8A

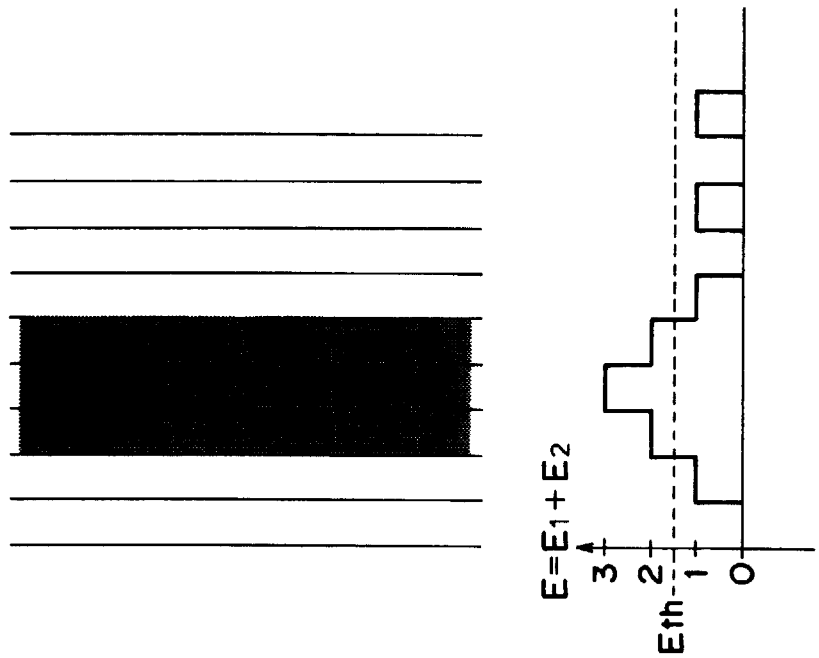


FIG. 9B

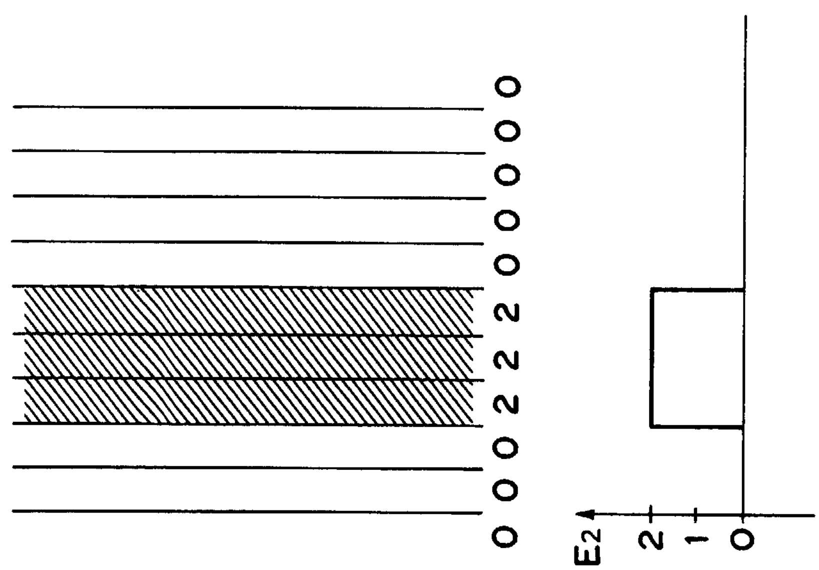


FIG. 9A

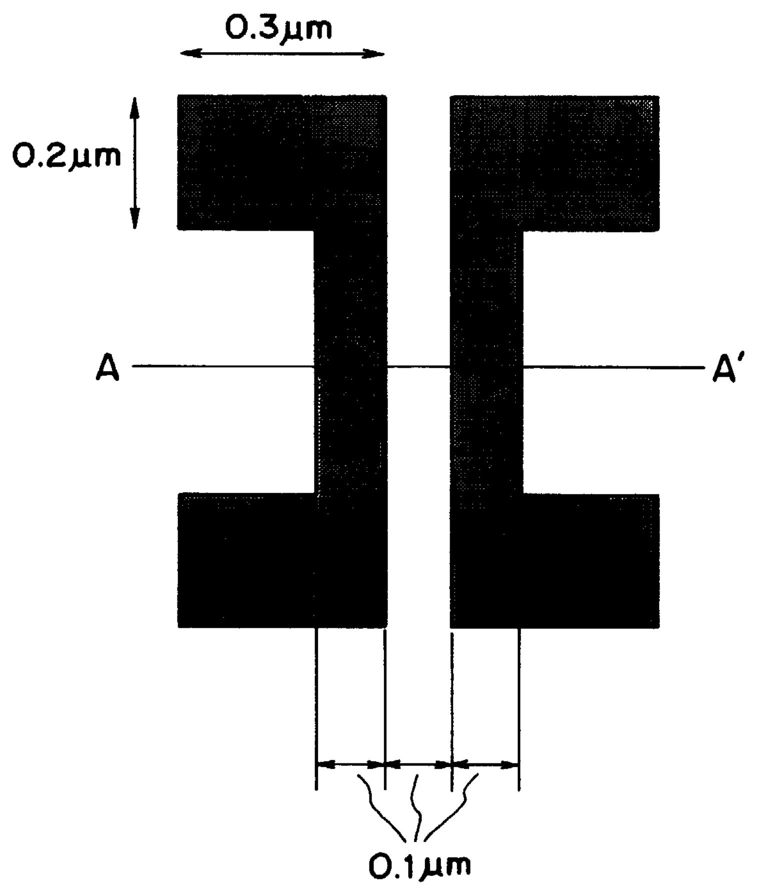


FIG. 10

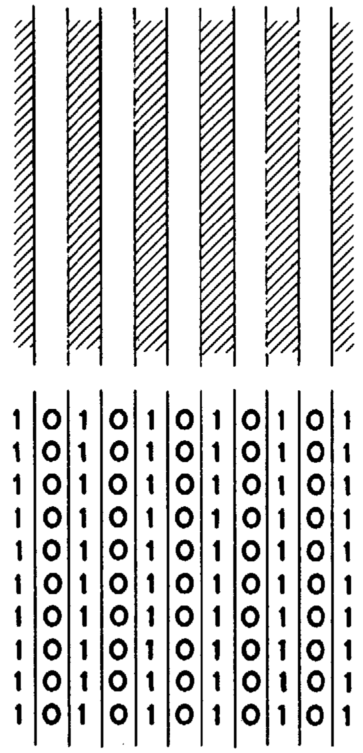

FIG. 11A

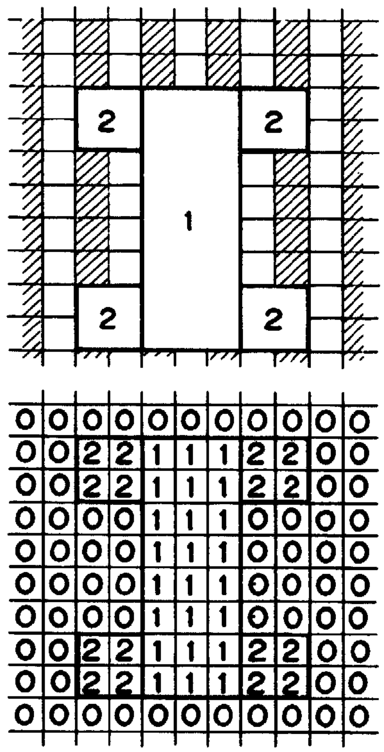

FIG. 11B

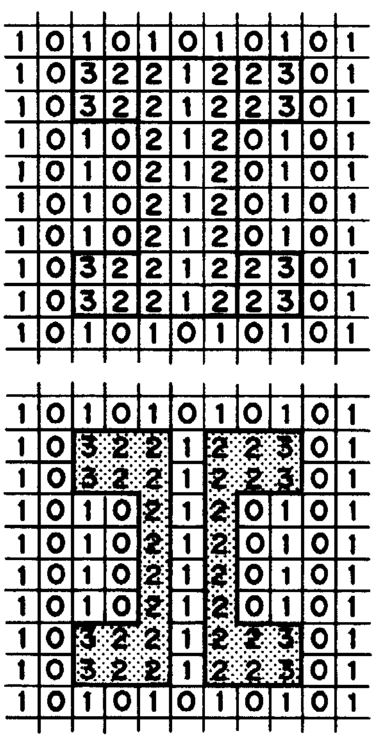

FIG. 11C

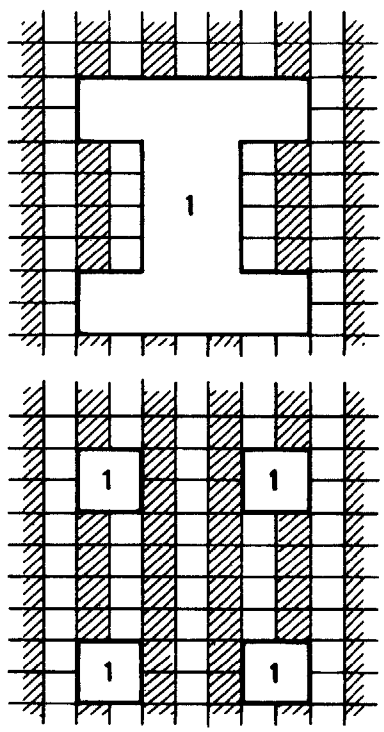

FIG. 11D

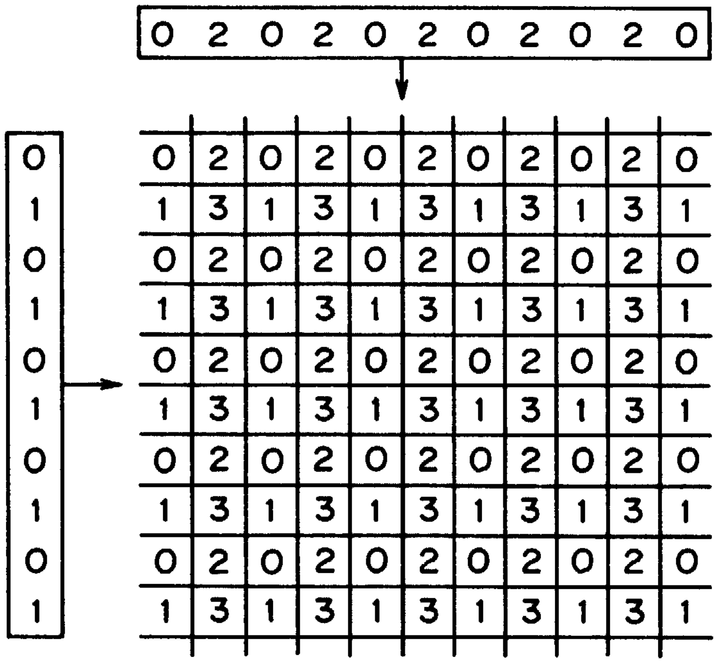

FIG. 12

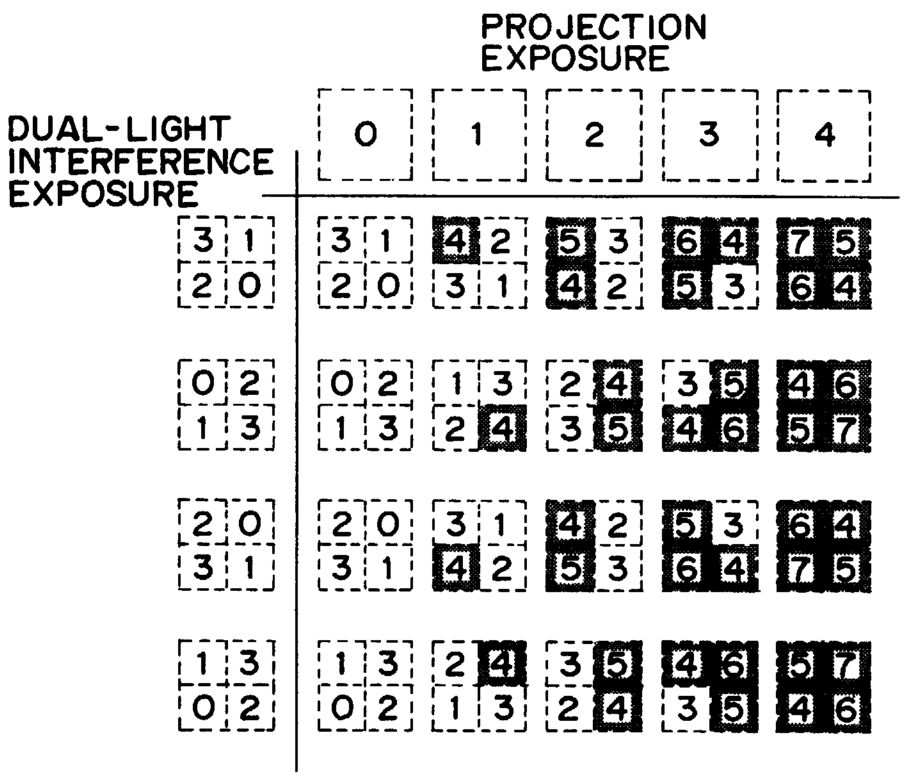
PROJECTION EXPOSURE
DUAL-LIGHT INTERFERENCE EXPOSURE
0
1
2
3
4

FIG. 13

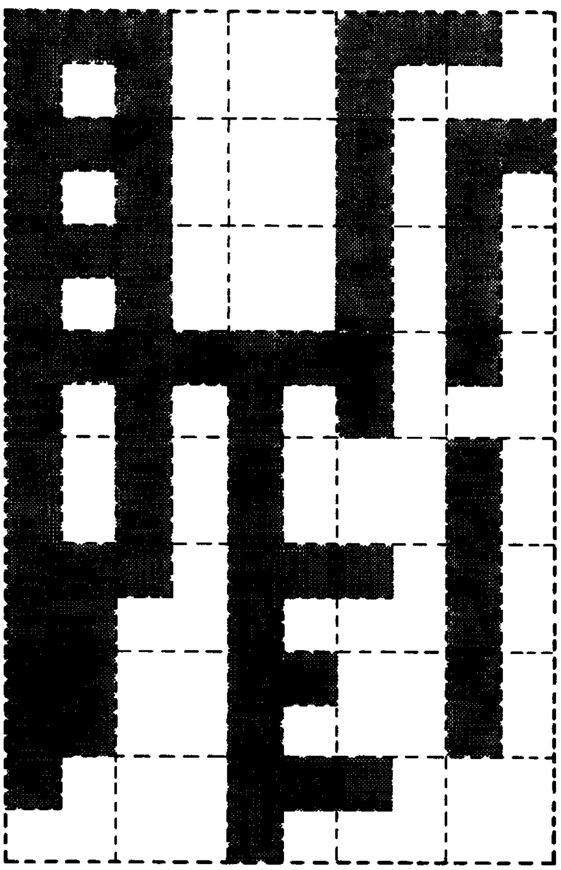

FIG. 14

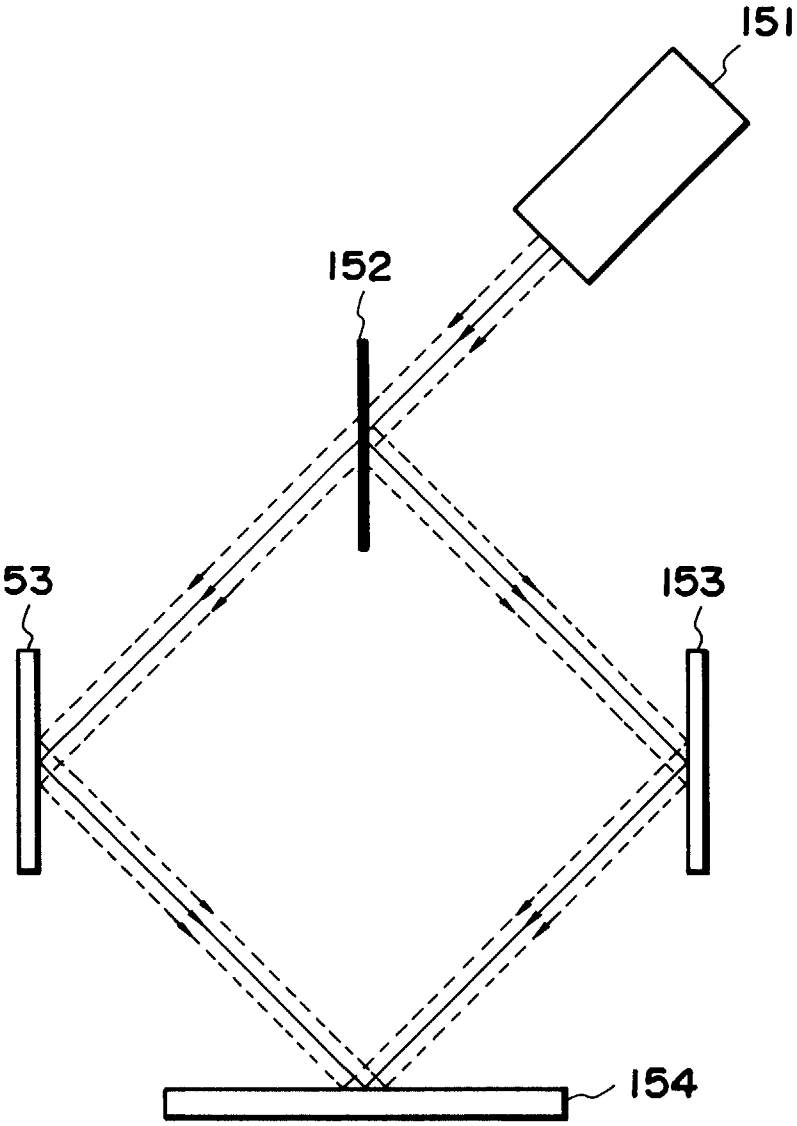


FIG. 15

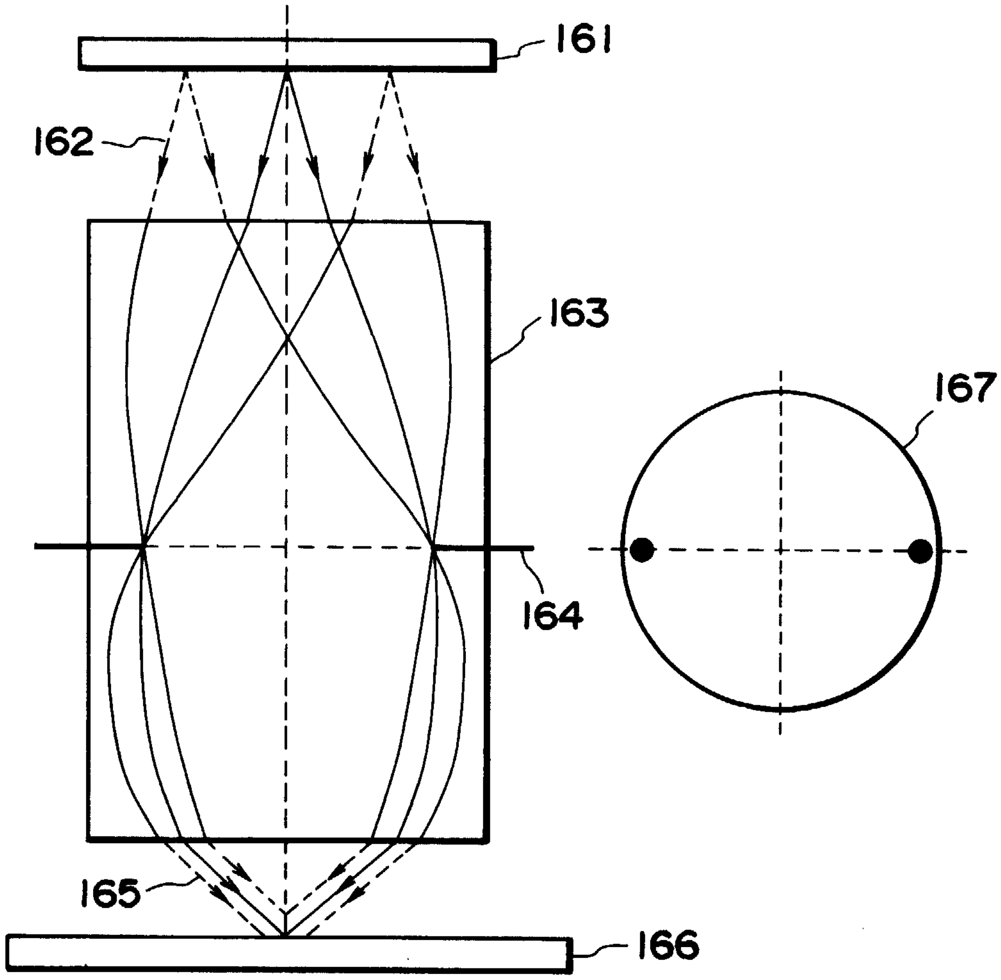


FIG. 16

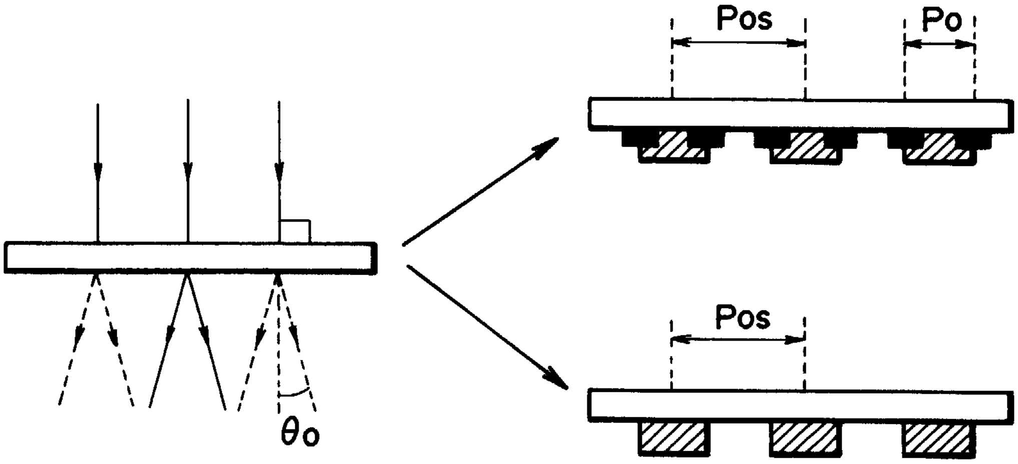


FIG. 17

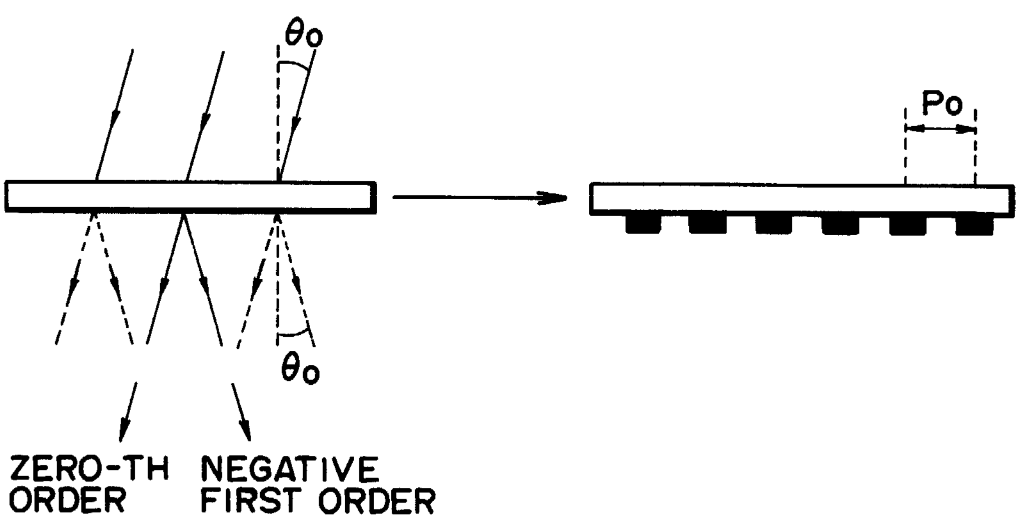


FIG. 18

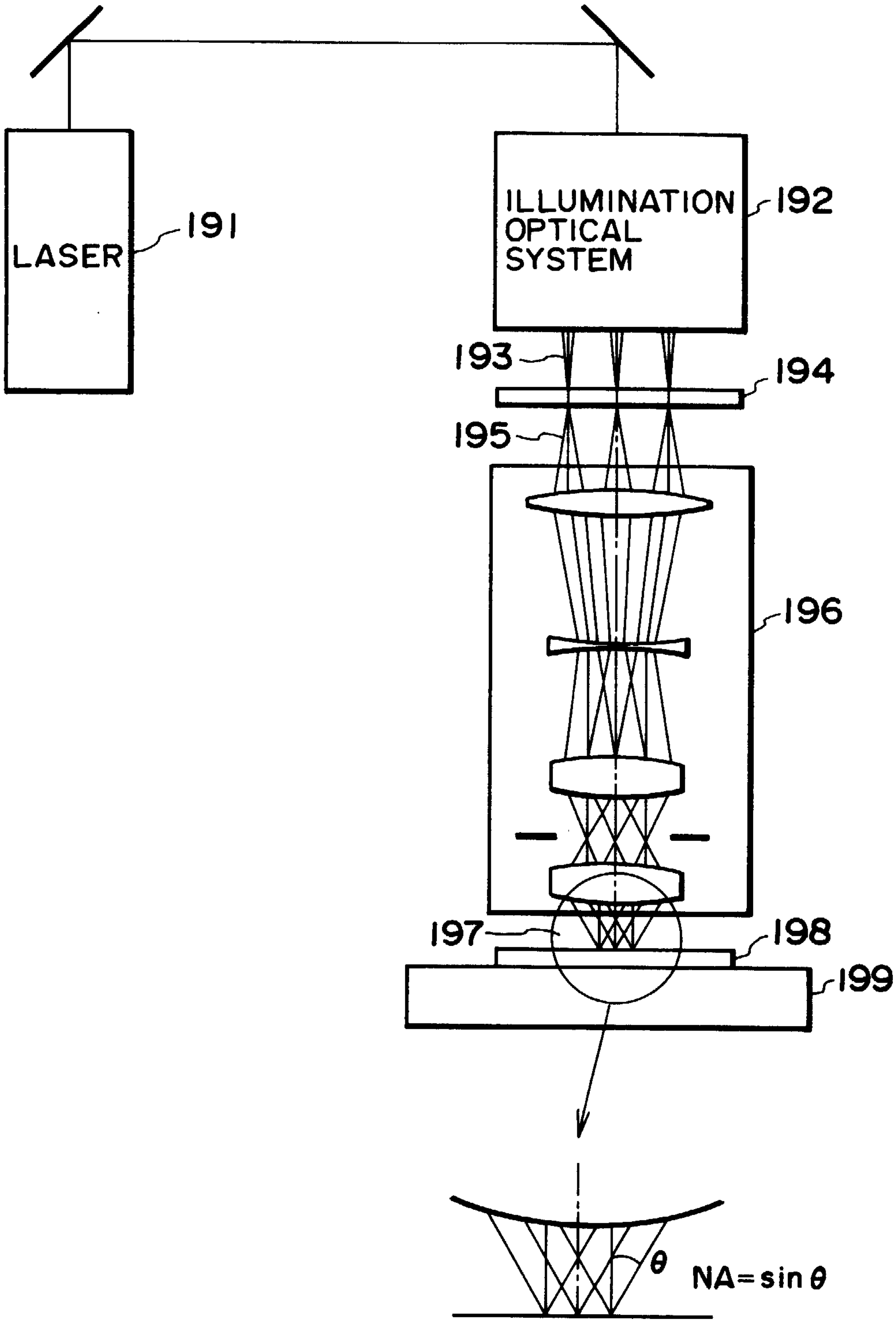
LASER
191
ILLUMINATION OPTICAL SYSTEM
192
193
194
195
196
197
198
199
θ
NA=sin θ

FIG. 19

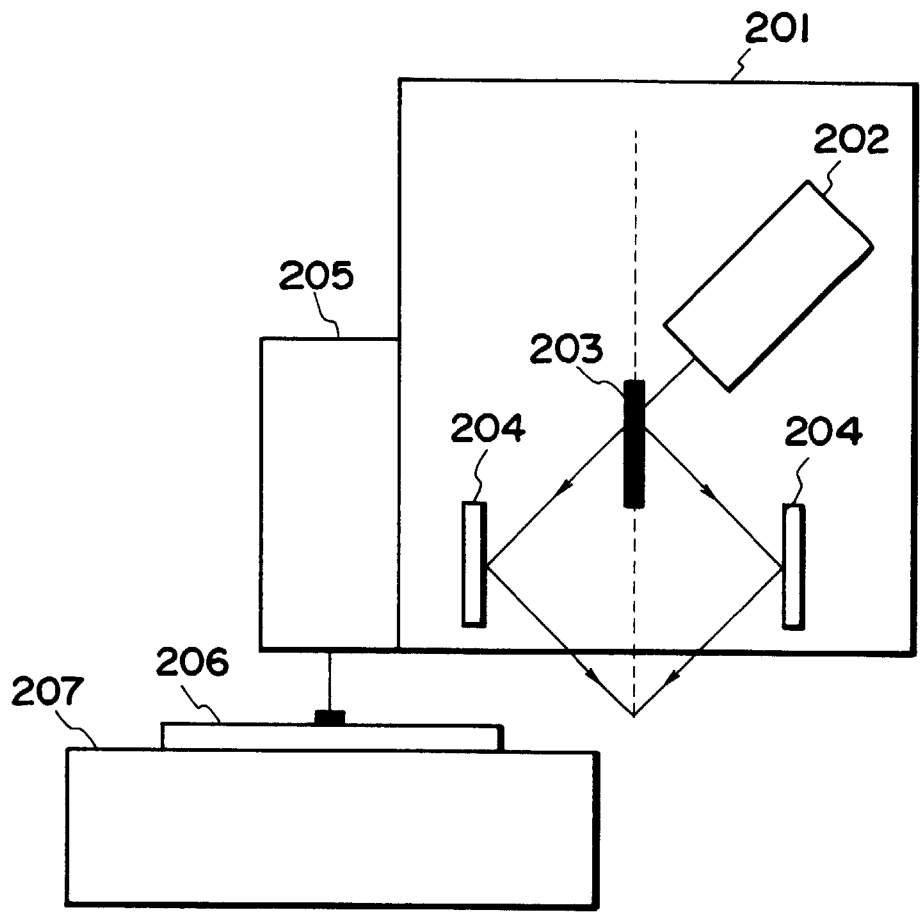


FIG. 20

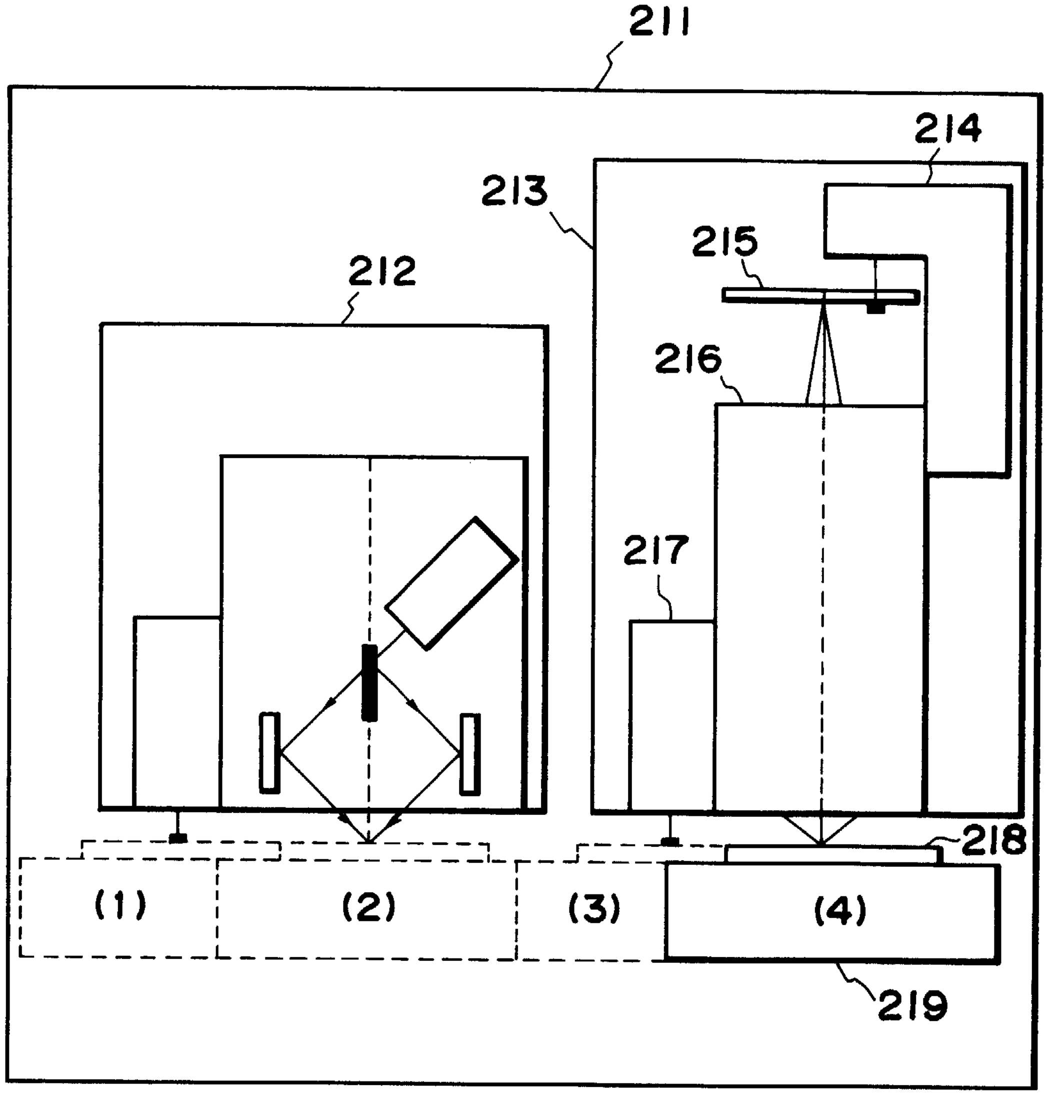


FIG. 21

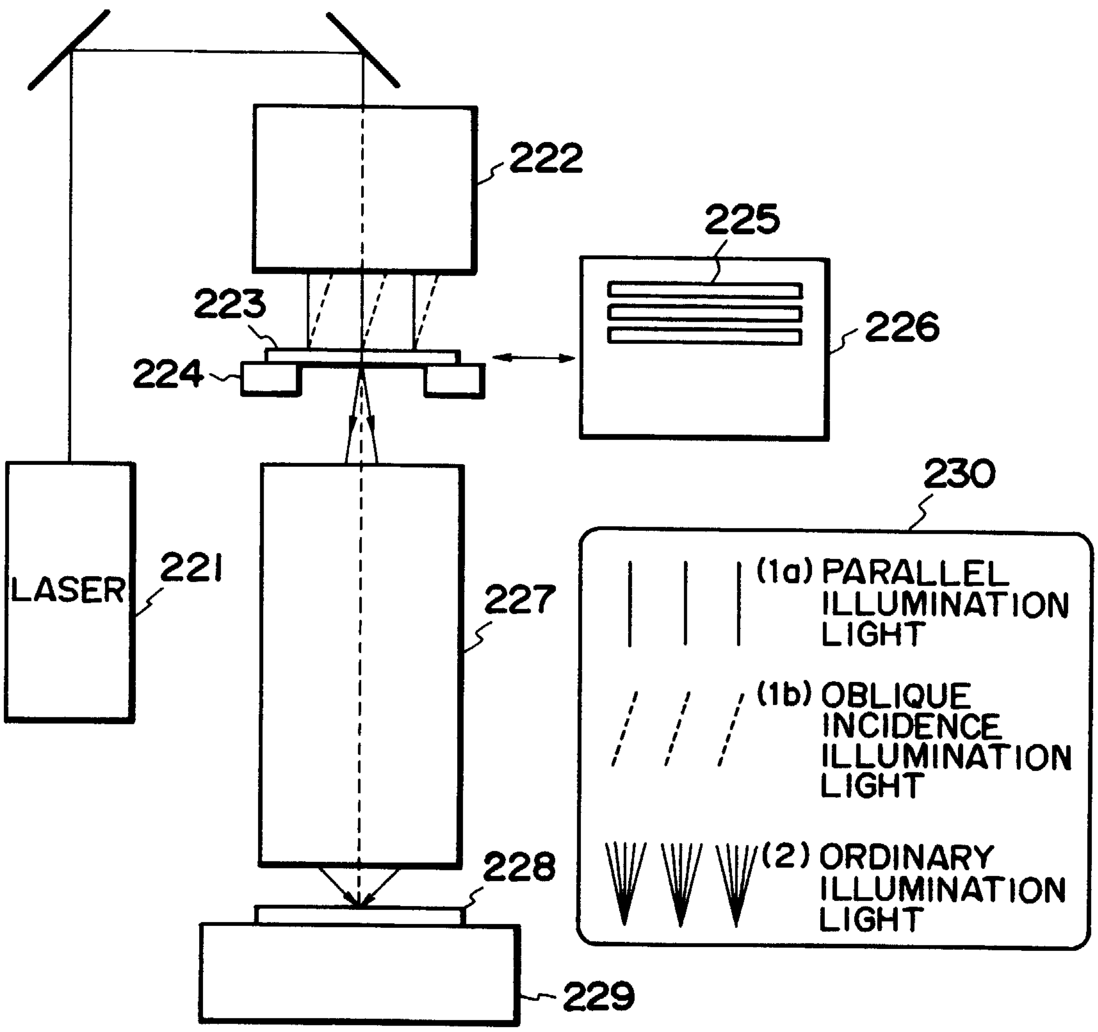
222
225
223
226
224
LASER
221
227
230
(1a) PARALLEL ILLUMINATION LIGHT
(1b) OBLIQUE INCIDENCE ILLUMINATION LIGHT
(2) ORDINARY ILLUMINATION LIGHT
228
229

FIG. 22